# EUROPÄISCHE PATENTSCHRIFT

(11) **EP 2 347 455 B1**
(45) Veröffentlichungstag und Bekanntmachung des Hinweises auf die Patenterteilung: **27.03.2013**
(21) Anmeldenummer: 09771686.4
(22) Anmeldetag: 05.11.2009
(51) Int. Cl.: H01L 33/44, C08G 61/10, H01L 31/02, C08G 61/02, H01L 31/0216

(54) **STRAHLUNGSEMITTIERENDES BAUELEMENT UND VERFAHREN ZU DESSEN HERSTELLUNG**
RADIATION-EMITTING COMPONENT AND METHOD FOR PRODUCING THE SAME
COMPOSANT ÉMETTANT UN RAYONNEMENT ET PROCÉDÉ POUR SA FABRICATION

(30) Priorität: 14.11.2008 DE 102008057350
(43) Veröffentlichungstag der Anmeldung: 27.07.2011
(73) Patentinhaber: OSRAM Opto Semiconductors GmbH, 93055 Regensburg (DE)
(72) Erfinder: HERRMANN, Siegfried, 94362 Neukirchen (DE); TAEGER, Sebastian, 93055 Regensburg (DE)
(74) Vertreter: Epping - Hermann - Fischer
(86) Internationale Anmeldenummer: PCT/DE2009/001571
(87) Internationale Veröffentlichungsnummer: WO 2010/054628

(56) Entgegenhaltungen:
- DE-A1-102005 063 106
- DE-A1-102006 045 702

## Beschreibung

Es wird ein strahlungsemittierendes Bauelement nach dem Anspruch 1 angegeben.

Ein weit verbreitetes Problem von strahlungsemittierenden Bauelementen ist die Erzeugung einer effizienten Verkapselung dieser Bauelemente. Das Material, welches für die Verkapselung verwendet wird soll zum einen eine sehr gute Barrierewirkung gegenüber beispielsweise Säuren, Laugen, Gasen und Wasserdampf aufweisen, soll aber gleichzeitig auch sehr dünne gleichförmige Schichten ausbilden und transparent für die vom Bauelement emittierte Strahlung sein.

Die Druckschrift DE10 2006 045 702 A1 offenbart ein optoelektronisches Bauelement umfassend:
- eine strahlungsemittierende Schichtenfolge, die eine erste Strahlung mit einem ersten Spektrum emittiert,
- zumindest einen Wellenlängenkonversionsbereich im Strahlengang der strahlungsemittierenden Schichtenfolge, der zumindest einen Teil der ersten Strahlung in eine zweite Strahlung mit einem zweiten Spektrum umwandelt, das zumindest teilweise vom ersten Spektrum verschieden ist, und
- zumindest ein Filterelement im Strahlengang der strahlungsemittierenden Schichtenfolge mit einem photonischen Kristall mit einer variabel einstellbaren Transmission für zumindest einen Teil des ersten Spektrums (siehe Absatz [0006]).
Außerdem wird in Absatz [0032] erwähnt, dass die funktionalen Schichten organische Polymere, insbesondere Polyphenylen, sein können.

Die Druckschrift DE10 2005 063 106 A1 offenbart einen optoelektronischen Halbleiterchip und optoelektronische Bauelemente mit solch einem Halbleiterchip, die gegen elektrische, mechanische und chemische Einflüsse gut geschützt sind. Der Halbleiterkörper weist eine Strahlungsdurchtrittsfläche auf, die von einer Passivierungsschicht bedeckt ist. Die Passivierungsschicht enthält ein Aluminiumnitrid bzw einen diamantartigen Nanoverbundwerkstoff.

Eine Aufgabe von Ausführungsformen der Erfindung besteht darin, ein strahlungsemittierendes Bauelement bereitzustellen, welches eine Passivierungsschicht aufweist, welche über eine sehr gute Barrierewirkung gegenüber beispielsweise Säuren, Laugen, Gasen und Wasserdampf aufweist und gleichzeitig transparent für die vom Bauelement emittierte Strahlung ist.

Die Aufgabe wird durch ein strahlungsemittierendes Bauelement nach dem Anspruch 1 gelöst. Weitere Ausführungsformen des strahlungsemittierenden Bauelements sowie Verfahren zur Herstellung des strahlungsemittierenden Bauelements sind Gegenstand weiterer Patentansprüche.

Eine Ausführungsform der Erfindung betrifft ein strahlungsemittierendes Bauelement, umfassend einen Träger, einen Halbleiterchip angeordnet auf den Träger, wobei der Halbleiterchip eine aktive Schicht zur Erzeugung von elektromagnetischer Strahlung und eine Strahlungsaustrittsfläche aufweist, eine erste und eine zweite Kontaktstruktur zur elektrischen Kontaktierung des Halbleiterchips, eine erste und eine zweite Kontaktschicht, wobei der Halbleiterchip über die erste Kontaktschicht mit der ersten Kontaktstruktur und über die zweite Kontaktschicht mit der zweiten Kontaktstruktur elektrisch leitend verbunden ist, eine Passivierungsschicht angeordnet auf dem Halbleiterchip, wobei die Passivierungsschicht ein organisches Polymer umfasst oder aus diesem besteht, mit der allgemeinen Formel (I): 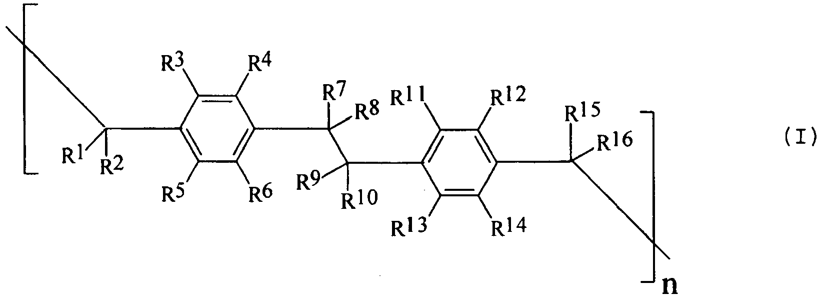 wobei die Reste R¹ bis R¹⁶ jeweils unabhängig voneinander H, CH₃, F, Cl oder Br sein können, und n ein Wert von 10 bis 500.000 hat.

Eine Passivierungsschicht, die ein organisches Polymer mit der oben angegebenen Formel umfasst weist eine gute hydrophobe und chemische Resistenz auf. Die Passivierungsschicht hat somit eine gute Barrierewirkung gegenüber beispielsweise Säuren, Laugen, Gasen und Wasserdampf. Die Passivierungsschicht ist des Weiteren transparent für die vom Bauelement emittierte Strahlung. Ein weiterer Vorteil der Passivierungsschicht ist, dass sich sehr dünne und gleichförmige Schichten ausbilden lassen. Des Weiteren weist die Passivierungsschicht eine gute Temperaturbeständigkeit auf. Sie weist auch eine gute Resistenz gegenüber mechanischer Belastung wie beispielsweise Abrieb auf. Durch diese Eigenschaften sind die Teile des strahlungsemittierenden Bauelements, welche mit der Passivierungsschicht beschichtet sind sehr gut gegenüber Umwelteinflüssen geschützt.

In einer weiteren Ausführungsform des strahlungsemittierenden Bauelements stehen jeweils R¹, R², R⁷, R⁸, R⁹, R¹⁰, R¹⁵ und R¹⁶ für H.

In einer weiteren Ausführungsform der Erfindung hat n einen Wert von 100 bis 100.000.

In einer weiteren Ausführungsform der Erfindung sind jeweils ein oder zwei Reste R³ bis R⁶ einerseits und R¹¹ bis R¹⁴ andererseits CH₃, F, Cl, Br.
Für den Fall, dass an einem Aromaten zwei Reste vorhanden sind, so handelt es sich vorzugsweise um die gleichen Reste.

Ein organisches Polymer dieser Formel weist eine besonders gute Barrierewirkung gegenüber Umwelteinflüssen auf. Gleichzeitig lassen sich besonders dünne und gleichförmige Passivierungsschichten auf dem Bauelement ausbilden.

In einer weiteren Ausführungsform umfasst die Passivierungsschicht ein organisches Polymer der Formel:

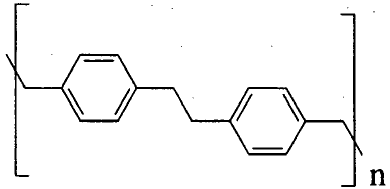

Eine Passivierungsschicht, welche ein solches organisches Polymer umfasst weist eine sehr gute dielektrische Festigkeit auf, wobei zusätzlich die dielektrische Konstante unabhängig von der Frequenz des elektrischen Feldes ist. Des Weiteren können mit einer Passivierungsschicht, welche ein solches organisches Polymer umfasst, besonders gleichförmige Schichten ausgebildet werden. Mit diesem Material können besonders gut kleine Räume, Spalten und Kanten ausgefüllt werden. Die Passivierungsschicht eignet sich auch besonders gut als Isolationsschicht aufgrund der dielektrischen Konstante und dem geringen dielektrischen Verlustfaktor des Polymers.

In einer weiteren Ausführungsform umfasst die Passivierungsschicht ein organisches Polymer der Formel:

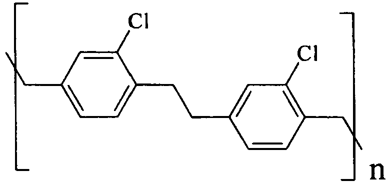

Eine Passivierungsschicht, welche das oben stehende organische Polymer umfasst weist sehr gute elektrische wie auch physikalische Eigenschaften auf. So weist die Passivierungsschicht eine sehr gute Barrierewirkung gegenüber Feuchtigkeit und Gasen auf. Eine Passivierungsschicht, welche ein solches organisches Polymer umfasst, haftet schneller an der Oberfläche an, auf die sie aufgetragen wird, verglichen zu dem entsprechenden organischen Polymer, welches keine Chloratome umfasst.

In einer weiteren Ausführungsform des strahlungsemittierenden Bauelements umfasst die Passivierungsschicht ein organisches Polymer der Formel:

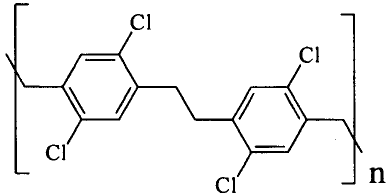

Eine Passivierungsschicht, welches ein organisches Polymer umfasst, dessen Aromat zwei Chloratome hat, weist gegenüber den Passivierungsschichten, deren organische Polymere Aromaten umfasst die nur ein oder kein Chloratom haben, eine höhere thermische Stabilität auf.

In einer weiteren Ausführungsform des strahlungsemittierenden Bauelements stellt die Passivierungsschicht zumindest in Teilbereichen die äußerste Schicht des Bauelements dar.

Aufgrund der sehr guten Barriereeigenschaften der Passivierungsschicht ist es möglich, das strahlungsemittierende Bauelement nach außen mit Hilfe der Passivierungsschicht gegenüber Umwelteinflüssen wie beispielsweise Gasen oder Wasserdampf oder chemisch aggressive Medien zu verkapseln. Hierbei kann die Passivierungsschicht die Außenschicht des Bauelements darstellen.
Unter Außenschicht ist eine Schicht zu verstehen, die bei einer Schichtenfolge von beispielsweise mehreren übereinander gelagerten horizontalen Schichten zumindest in Teilbereichen die oberste oder unterste Schicht darstellt. Nicht als Außenschicht ist eine Schicht zu verstehen, welche zwischen anderen Schichten angeordnet ist, und lediglich an den vertikalen Seitenflächen Kontakt zur Umgebung aufweist.

In einer weiteren Ausführungsform des strahlungsemittierenden Bauelements ist die Passivierungsschicht auf der Strahlungsaustrittsfläche angeordnet.

Die Schichtdicke kann bei dieser Ausführungsform in einem Bereich von 100 nm bis 2000 nm liegen, vorzugsweise in einem Bereich von 200 nm bis 1000 nm.

Aufgrund der Transparenz der Passivierungsschicht kann diese auf der Strahlungsaustrittsfläche des Halbleiterchips aufgebracht werden. Somit kann der Halbleiterchip durch die Passivierungsschicht gegenüber Umwelteinflüssen verkapselt werden.

In einer weiteren Ausführungsform des Bauelements ist die Passivierungsschicht direkt auf der Strahlungsaustrittsfläche angeordnet.

Unter direkt auf der Strahlungsfläche angeordnet ist zu verstehen, dass sich zumindest in Teilbereichen zwischen der Passivierungsschicht und der Halbleiterschicht keine weiteren Zwischenschichten befinden. Die sehr guten Barriereeigenschaften der Passivierungsschicht machen es möglich, dass auf weitere Barriereschichten verzichtet werden kann. Dies kombiniert mit der Eigenschaft, dass die Passivierungsschicht als sehr dünne und sehr gleichförmige Schicht ausgeformt werden kann, ermöglichen es, sehr flache Bauelemente zu realisieren.

In einer weiteren Ausführungsform des strahlungsemittierenden Bauelements ist auf der Strahlungsaustrittsfläche des Halbleiterchips zumindest ein optisches Element angeordnet.

Durch das optische Element kann die vom Halbleiterchip emittierte Strahlung beispielsweise räumlich umgelenkt oder in ihrer Wellenlänge modifiziert werden.

In einer weiteren Ausführungsform des strahlungsemittierenden Bauelements umfasst das optische Element eine Konversionsschicht oder ein Filter.

In der Konversionsschicht kann die vom Halbleiterchip emittierte Strahlung in ihrer Wellenlänge modifiziert werden. Dies kann beispielsweise auch nur mit einem bestimmten Wellenlängenbereich der emittierten Strahlung geschehen. Die Modifikation kann beispielsweise durch Absorption der Strahlung durch einen Konversionsstoff erfolgen, welcher Strahlung dann wieder in einer anderen Wellenlänge emittiert. Bei dem Filter kann es sich beispielsweise um einen Winkel- oder Kantenfilter handeln.

In einer weiteren Ausführungsform des strahlungsemittierenden Bauelements ist die Passivierungsschicht zumindest auf Teilbereichen der vom Halbleiterchip abgewandten Oberfläche des optischen Elements angeordnet.

Bei dieser Ausführungsform wird nicht nur der Halbleiterchip, sondern auch noch zusätzlich das auf dem Halbleiterchip angeordnete optische Element durch die Passivierungsschicht verkapselt. Hierdurch wird nicht nur der Halbleiterchip sondern auch das optische Element vor Umwelteinflüssen geschützt. Es sind auch Ausführungsbeispiele denkbar, bei denen noch zusätzlich zwischen dem Halbleiterchip und dem optischen Element eine Ausgleichsschicht angeordnet ist. Die Ausgleichsschicht stellt hierbei eine Sonderform der Passivierungsschicht dar und umfasst somit die gleichen Substanzen wie die Passivierungsschicht. Diese kann beispielsweise zur Begradigung der Oberfläche des Halbleiterchips dienen.

In einer weiteren Ausführungsform des strahlungsemittierenden Bauelements isoliert die Passivierungsschicht die erste Kontaktstruktur elektrisch gegen die zweite Kontaktstruktur.

Aufgrund der guten elektrisch isolierenden Eigenschaften des organischen Polymers kann die Passivierungsschicht auch als elektrischer Isolator eingesetzt werden. Hierbei kann beispielsweise die erste gegen die zweite Kontaktstruktur elektrisch isoliert werden.

In einer weiteren Ausführungsform des strahlungsemittierenden Bauelements isoliert die Passivierungsschicht die zweite Kontaktschicht elektrisch gegen die erste Kontaktstruktur.

Da das organische Polymer und somit auch die Passivierungsschicht nicht nur sehr gute elektrisch isolierende Eigenschaften aufweist, sondern mit ihr auch sehr dünne und gleichförmige Schichten ausgebildet werden können, ist es möglich auch kleine Zwischenräume mit der Passivierungsschicht auszufüllen. Des Weiteren ist es auch möglich Kontaktschichten rampenartig über einen Sockel, welcher durch die Passivierungsschicht ausgebildet wird, zu führen. Untel rampenartig ist zu verstehen, dass die Kontaktschicht direkt über eine andere Schicht geführt wird, ohne dass eine Zwischenraum zwischen der Kontaktschicht und der Schicht über die sie geführt wird ausgebildet wird. Dies ermöglicht es, besonders flache Bauelemente zu realisieren. Bei dieser Ausführungsform, welche eine solche Kontaktrampe aufweist, wird kein Kontaktdraht (ein so genannter Bonddraht) benötigt.

In einer weiteren Ausführungsform des strahlungsemittierenden Bauelements ist die zweite Kontaktschicht auf der Strahlungsaustrittsfläche des Halbleiterchips rahmenförmig angeordnet.

Dies ermöglicht es, dass der Halbleiterchip auch auf der Seite der Strahlungsaustrittsfläche von allen Seiten mit Spannung versorgt werden kann. Somit weist der Halbleiterchip eine gleichförmigere Spannungsversorgung auf, als wenn die Kontaktschicht nur an einer Seite der Strahlungsaustrittsfläche angeordnet wäre. Dadurch, dass der Halbleiterchip gleichmäßiger mit Spannung versorgt wird, weist er eine homogenere Abstrahlung auf, verglichen mit einem Halbleiterchip, welcher nur punktuell oder über eine Kante mit Spannung versorgt wird.
Durch die rahmenförmige Anordnung der zweiten Kontaktschicht auf der Oberfläche des Halbleiterchips verbessert sich die Stromaufweitung des Halbleiterchips, wodurch die Effizienz der Strahlungserzeugung verbessert wird. Die rahmenförmige Kontaktgeometrie der zweiten Kontaktschicht eignet sich besonders für Chips mit einer Seitenlänge von weniger als 400 µm.

In einer weiteren Ausführungsform des strahlungsemittierenden Bauelements weist die zweite Kontaktschicht Kontaktstege auf, die auf der Strahlungsaustrittsfläche des Halbleiterchips angeordnet sind.

Diese Anordnung der zweiten Kontaktschicht ermöglicht es ebenfalls den Halbleiterchip homogen mit Spannung zu versorgen, was wiederum zu einer homogenen Abstrahlung des Halbleiterchips führt. Die Kontaktstege können hierbei transparent für die emittierte Strahlung sein. Hierbei ist die zweite Kontaktschicht bevorzugt zusätzlich rahmenförmig auf der Oberfläche des Halbleiterchips angeordnet, wobei in diesem Rahmenkontakt Kontaktstege angeordnet sind, die sich vorzugsweise auf der Oberfläche des Halbleiterchips nicht kreuzen und besonders bevorzugt parallel zueinander verlaufen. Die Kontaktstege stehen dabei in Teilbereichen in direktem Kontakt mit dem Rahmenkontakt.
Durch die Kontaktstege verbessert sich die Stromaufweitung des Halbleiterchips, wodurch größere Chipabmessungen möglich sind. Eine solche Kontaktstruktur ist besonders vorteilhaft für Chips mit einer Seitenlänge von größer als 400 µm.

In einer weiteren Ausführungsform des strahlungsemittierenden Bauelements ist im Träger eine erste und eine zweite Durchkontaktierung vorhanden, wobei die erste Durchkontaktierung mit der ersten Kontaktstruktur und die zweite Durchkontaktierung mit der zweiten Kontaktstruktur elektrisch leitend verbunden sind.

Dies ermöglicht es, dass die erste beziehungsweise zweite Kontaktstruktur von der Unterseite also durch den Träger hindurch elektrisch kontaktiert werden können. Somit können sehr flache Bauelemente realisiert werden. Durch eine Kontaktierung des Halbleiterchips über Durchkontaktierungen, die durch den Träger führen, kann das strahlungsemittierende Bauelement oberflächenmontierbar ausgebildet sein. Oberflächenmontierbare Bauelemente, oder auch so genannte SMT-Bauelemente (SMT: Surface Mount Technology), zeichnen sich dadurch aus, dass sie mittels lötfähigen Kontaktbereichen direkt beispielsweise auf eine Leiterplatte gelötet werden können. Dadurch werden sehr dichte Bestückungen möglich, wodurch sich der Platzbedarf verringert. Dies erlaubt eine hohe Packungsdichte.

In einer weiteren Ausführungsform des strahlungsemittierenden Bauelements ist das Bauelement als Dünnfilmchip ausgeformt.

Bei einer weiteren Ausgestaltung ist der Halbleiterkörper ein Dünnfilm-Leuchtdiodenchip. Insbesondere weist er an seiner Rückseite ein Trägersubstrat auf. Bei einer Ausgestaltung sind die erste und die zweite Anschlussschicht zumindest stellenweise zwischen der Halbleiterschichtenfolge und dem Trägersubstrat angeordnet.

Ein Dünnfilm-Leuchtdiodenchip zeichnet sich durch mindestens eines der folgenden charakteristischen Merkmale aus:
- an einer zu einem Trägerelement, insbesondere dem Trägersubstrat, hingewandten Hauptfläche der strahlungserzeugenden Halbleiterschichtenfolge, bei der es sich insbesondere um eine strahlungserzeugende Epitaxie-Schichtenfolge handelt, ist eine reflektierende Schicht aufgebracht oder ausgebildet, die zumindest einen Teil der in der Halbleiterschichtenfolge erzeugten elektromagnetischen Strahlung in diese zurückreflektiert;
- der Dünnfilm-Leuchtdiodenchip weist ein Trägerelement auf, bei dem es sich nicht um das Wachstumssubstrat handelt, auf dem die Halbleiterschichtenfolge epitaktisch gewachsen wurde, sondern um ein separates Trägerelement, das nachträglich an der Halbleiterschichtenfolge befestigt wurde;
- die Halbleiterschichtenfolge weist eine Dicke im Bereich von 20 µm oder weniger, insbesondere im Bereich von 10 µm oder weniger auf;
- die Halbleiterschichtenfolge ist frei von einem Aufwachssubstrat. Vorliegend bedeutet "frei von einem Aufwachssubstrat, dass ein gegebenenfalls zum Aufwachsen benutztes Aufwachssubstrat von der Halbleiterschichtenfolge entfernt oder zumindest stark gedünnt ist. Insbesondere ist es dann derart gedünnt, dass es für sich oder zusammen mit der Epitaxie-Schichtenfolge alleine nicht freitragend ist. Der verbleibende Rest des stark gedünnten Aufwachssubstrats ist insbesondere als solches für die Funktion eines Aufwachssubstrates ungeeignet; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.

Ein Grundprinzip eines Dünnfilm-Leuchtdiodenchips ist beispielsweise in der Druckschrift I. Schnitzer et al., Appl. Phys. Lett. 63 (16) 18. Oktober 1993, Seiten 2174 - 2176 beschrieben. Beispiele für Dünnfilm-Leuchtdiodenchips sind in den Druckschriften EP 0905797 A2 und WO 02/13281 A1 beschrieben.

In einer weiteren Ausführungsform erscheint das Bauelement vollständig weiß. Durch eine sehr dünne und transparente Verkapselung mittels der erfindungsgemäßen Passivierungsschicht kann eine Veränderung des Farbeindrucks durch die Passivierungsschicht vermieden werden.

Mittels der Passivierungsschicht können Bauteile, wie beispielsweise LED-Chips, verkapselt werden, deren Kontakte sowohl als Zwischenschichten ausgebildet sind, wie auch Bauteile, bei denen sich die Kontakte zur elektrischen Kontaktierung an der Oberfläche befinden.

Die Passivierungsschicht kann, beispielsweise für den Fall, dass diese an den Chipflanken angeordnet ist, auch als elektrischer Überschlagsschutz gegenüber einem elektrisch leitenden Grundkörper / Träger Anwendung finden.

Des Weiteren kann die Passivierungsschicht auch zur Passivierung für eine Spiegelschicht, beispielsweise im Halbleiterchip, genutzt werden.

Neben dem Bauelement selbst wird auch ein Verfahren zu dessen Herstellung beansprucht.

Eine Variante zur Herstellung des strahlungsemittierenden Bauelements umfasst die Verfahrensschritte das Bereitstellen eines Trägers, der eine erste und eine zweite Kontaktstruktur aufweist als Verfahrensschritt A), das mechanische und elektrisch leitende Verbinden des Halbleiterchips mit der ersten Kontaktstruktur über die erste Kontaktschicht als Verfahrensschritt B), das mechanische und elektrisch leitende Verbinden des Halbleiterchips mit der ersten Kontaktstruktur über die zweite Kontaktschicht als Verfahrens C), das Aufbringen der Passivierungsschicht auf zumindest Teilbereichen des Halbleiterchips als Verfahrensschritt D) wobei für die Passivierungsschicht ein Material verwendet wird, welches ein organisches Polymer umfasst, mit der allgemeinen Formel (I): 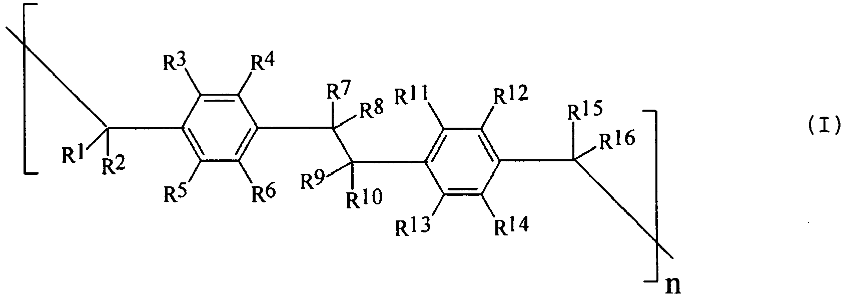 wobei die Reste R¹ bis R¹⁶ jeweils unabhängig voneinander H, CH₃, F, Cl oder Br sein können und n ein Wert von 10 bis 500.000 hat.

In einem solchen Verfahren kann beispielsweise ein strahlungsemittierendes Bauelement hergestellt werden, wie es in Anspruch 1 beansprucht wird. Anhand dieses Verfahrens können Bauelement realisiert werden, welche sehr gut gegen Umwelteinflüsse wie beispielsweise Säuren, Laugen, Gase und Wasserdampf geschützt sind. Des Weiteren können mit Hilfe dieses Verfahrens sehr flache Bauelemente realisiert werden. Weitere Vorteilhafte Ausgestaltungen des Verfahrens ergeben sich analog zu den vorteilhaften Ausgestaltungen des strahlungsemittierenden Bauelements.

In einer weiteren Variante des Verfahrens wird die Passivierungsschicht mit einem Plasma-Verfahren aufgebracht.

Bei dem Plasma-Verfahren kann beispielsweise das entsprechende Dimer des jeweiligen Polymers als Ausgangssubstanz dienen. Dieses kann beispielsweise thermisch in das Monomer aufgespaltet werden, aus dem dann die Kettenbildung zum Polymer erfolgt. Die Polymerisation erfolgt dann bei einer Temperatur, die geringer ist als die zur Spaltung des Dimers nötige Temperatur. Die Polymerisation kann bei einem Druck im Bereich von 0,05 bis 0,5 mbar erfolgen. Die Kondensation des Polymers kann dann direkt auf der zu beschichtenden Oberfläche erfolgen.

Mit Hilfe des Plasma-Verfahrens können sehr dünne und sehr gleichförmige Schichten aufgebracht werden, welche trotzdem eine sehr gute Barrierewirkung aufweisen.

Das Abscheiden der Passivierungsschicht kann auch mittels chemischer Gasphasenabscheidung (CVD) oder plasmaunterstützter chemischer Gasphasenabscheidung (PECVD) erfolgen.

Im Folgenden sollen Varianten der Erfindung anhand von Figuren und Ausführungsbeispielen näher erläutert werden.
Figur 1 zeigt eine schematische Seitenansicht einer Ausführungsform der strahlungsemittierenden Vorrichtung, bei der die zweite Kontaktschicht als Rampe ausgeformt ist.
Figur 2 zeigt eine schematische Aufsicht einer Ausführungsform des strahlungsemittierenden Bauelements wobei Teilbereiche der zweiten Kontaktschicht als Kontaktstege ausgeformt sind.
Figur 3 zeigt eine schematische Aufsicht einer Ausführungsform des strahlungsemittierenden Bauelements bei dem die Kontaktstege rahmenförmig verbunden sind.
Figur 4 zeigt eine schematische Aufsicht einer weiteren Ausführungsform des strahlungsemittierenden Bauelements welches einen symmetrischen Aufbau aufweist.
Figur 5 zeigt eine schematische Seitenansicht einer Ausführungsform des strahlungsemittierenden Bauelements bei dem die gesamte Außenfläche mit Ausnahme der Kontaktfläche mit der Passivierungsschicht umgeben ist.
Figur 6 zeigt eine schematische Seitenansicht einer Ausführungsform des strahlungsemittierenden Bauelements welches ein optisches Element in Form eines Konverters aufweist.
Figur 7a zeigt eine schematische Seitenansicht einer Ausführungsform eines strahlungsemittierenden Bauelements welches ein optisches Element in Form von Pyramidenfiltern aufweist.
Figur 7b zeigt eine schematische Seitenansicht einer Ausführungsform des strahlungsemittierenden Bauelements welches ein passives Bauelement aufweist.

Die Figurenfolge 8a bis 8d zeigt eine Mehrzahl von strahlungsemittierenden Bauelementen in verschiedenen Verfahrensstufen.

Die Figurenfolge 9a bis 9d zeigt ein strahlungsemittierendes Bauelement in der schematischen Aufsicht in verschiedenen Verfahrensstufen.

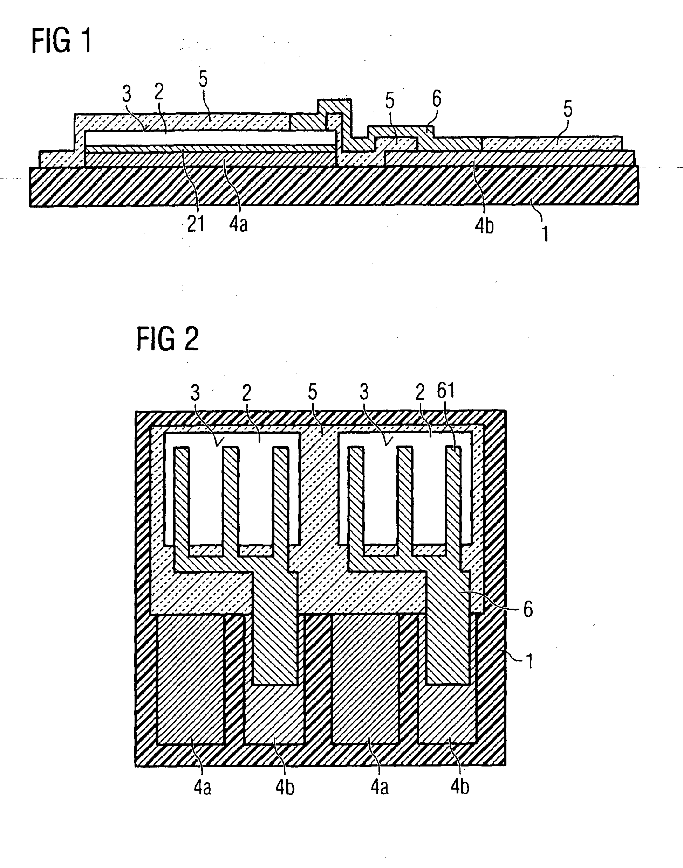

Die Figur 1 zeigt eine schematische Seitenansicht einer Ausführungsform des strahlungsemittierenden Bauelements. Auf dem Träger 1 sind die ersten Kontaktstruktur 4a und die zweite Kontaktstruktur 4b angeordnet. Die beiden Kontaktstrukturen sind durch die Passivierungsschicht 5 voneinander elektrisch isoliert. Der Halbleiterchip 2 ist über die erste Kontaktschicht 21 sowohl mechanisch wie auch elektrisch leitend mit der ersten Kontaktstruktur 4a verbunden. Der Halbleiterchip 2 weist eine Strahlungsaustrittsfläche 3 auf. Der Halbleiterchip 2 ist an der Strahlungsaustrittsfläche 3 über die zweite Kontaktschicht 6 elektrisch leitend mit der zweiten Kontaktstruktur 4b verbunden. Die zweite Kontaktschicht 6 wird hierbei rampenförmig über die Passivierungsschicht 5 geführt, wobei die Passivierungsschicht 5 die zweite Kontaktschicht 6 hierbei gegen die erste Kontaktstruktur 4a elektrisch isoliert. Die Bereiche der Strahlungsaustrittsfläche 3, welche nicht in Kontakt mit der zweiten Kontaktschicht 6 stehen sowie die Seitenflächen des Halbleiterchips 2 sind mit der Passivierungsschicht 5 beschichtet. Hierdurch ist der Halbleiterchip 2 gegenüber Umwelteinflüssen geschützt. Da die Passivierungsschicht 5 transparent für die vom Halbleiterchip 2 emittierte Strahlung ist, kann die Strahlung über die Strahlungsaustrittsfläche 3 durch die Passivierungsschicht 5 hindurch abgegeben werden.

Durch die Kontaktierung des Halbleiterchips 2, die ohne Bonddraht erfolgen kann, können optische Elemente chipnah an dem Halbleiterchip 2 angeordnet werden.

Der Träger 1 enthält bevorzugt eine Keramik, Silizium oder Aluminiumnitrid. Alternativ kann der Träger 1 eine intermetallische Keramik, ein Metall oder eine Metalllegierung mit einer darauf angeordneten elektrisch isolierenden Schicht, beispielsweise ein Dielektrikum, umfassen.

Der Halbleiterchip 2 weist eine aktive Schicht auf, welche einen pn-Übergang, eine Doppelheterostruktur, eine Einfachquantentopfstruktur (SQW) oder eine Mehrfachquantentopfstruktur (MQW) zur Strahlungserzeugung aufweisen kann.

Der Halbleiterchip 2 basiert bevorzugt auf einem Nitrid-, einem Phosphit- oder einem Arsenidverbindungshalbleiter. "Auf Nitrid-, Phosphit- oder Arsenidverbindungshalbleitern basierend" bedeutet im vorliegenden Zusammenhang, dass die aktive Epitaxieschichtenfolge oder zumindest eine Schicht davon ein III/V-Halbleitermaterial insbesondere mit der Zusammensetzung InₓGa_{y}Al_{1-x-y}P oder InₓGa_{y}Al_{1-x-y}N oder InₓGa_{y}Al₁₋ₓ₋yAs, jeweils mit 0 ≤ x ≤ 1, 0 ≤ y ≤ 1 und x + y < 1, umfasst.

Der Halbleiterchip 2 des strahlungsemittierenden Bauelements weist kein Aufwachssubstrat auf. Der Halbleiterchip 2 ist somit als substratloser Halbleiterchip ausgebildet.
Durch einen substratlosen Halbleiterchip 2 ergibt sich mit Vorteil eine besonders geringe Bauhöhe des Bauelements. Bevorzugt weist der Halbleiterchip 2 eine Höhe von weniger als 100 µm, besonders bevorzugt von weniger als 40 µm auf. Die Abmessung des Bauelements kann so nahezu im Bereich der Dicke einer Epitaxieschichtenfolge liegen.

Die erste Kontaktschicht 21 dient bevorzugt nicht nur der elektrischen Kontaktierung des Halbleiterchips 2, sondern kann ferner die Funktion eines optischen Spiegels übernehmen. Das bedeutet, dass die erste Kontaktschicht 21 die von dem Halbleiterchip 2 emittierte Strahlung, die in Richtung Träger 1 emittiert wird, vorzugsweise in Richtung der Strahlungsaustrittsfläche 3 des Halbleiterchips 2 zurückreflektiert.

Bevorzugt ist die zweite Kontaktschicht 6 transparent und ist insbesondere eine TCO-Schicht (TCO: Transparent Conductive Oxide). Besonders bevorzugt umfasst die zweite Kontaktschicht IZO (Indium-Zink-Oxid), ITO (Indium-Zinn-Oxid) oder ZnO (Zink-Oxid).

Bevorzugt weist die zweite Kontaktschicht 6 eine Dicke in einem Bereich zwischen einschließlich 50 nm und einschließlich 300 nm auf. Der Halbleiterchip 2 weist bevorzugt eine Höhe von weniger als 40 µm auf.

Die Figur 2 zeigt die schematische Aufsicht zweier strahlungsemittierender Bauelemente. Die beiden Bauelemente sind baugleich und auf dem gleichen Träger 1 angeordnet. Auf dem Träger 1 ist jeweils eine erste Kontaktstruktur 4a angeordnet über die der Halbleiterchip beziehungsweise die erste Kontaktschicht 21 welche zwischen dem Halbleiterchip 2 und der ersten Kontaktstruktur 4a angeordnet ist kontaktiert werden kann. Die Oberseite des Halbleiterchips 2 ist elektrisch leitend über die zweite Kontaktschicht 6 mit der zweiten Kontaktstruktur 4a verbunden. Die zweite Kontaktschicht 6 ist hierbei auf der Strahlungsaustrittsfläche 3 als Kontaktstege 61 ausgeformt. Diese Kontaktstege 61 ermöglichen es den Halbleiterchip 2 homogener mit Spannung zu versorgen, was zu einer homogeneren Abstrahlung des Halbleiterchips 2 führt. Die beiden Halbleiterchips 2 sind jeweils rahmenförmig durch die Passivierungsschicht 5 umgeben. Die zweite Kontaktschicht 6 wird hierbei wie in Figur 1 dargestellt rampenförmig über einen Teilbereich der Passivierungsschicht 5 zur Strahlungsaustrittsfläche 3 geführt.

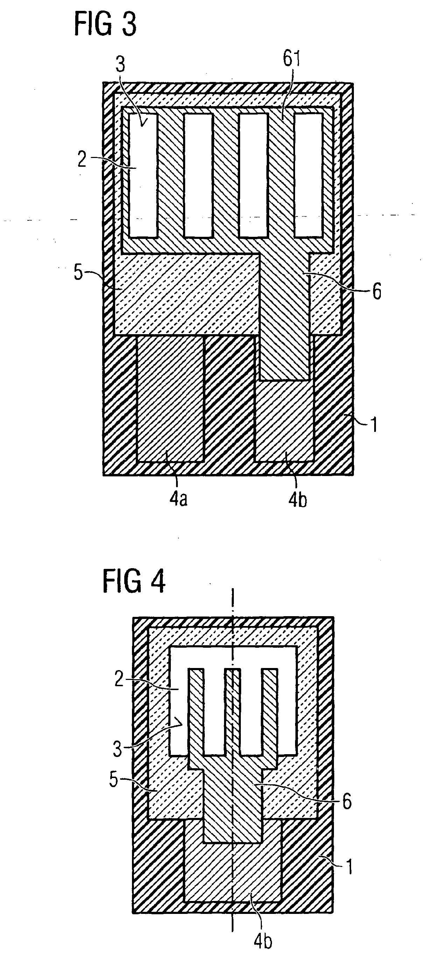

Die Figur 3 zeigt eine schematische Aufsicht einer weiteren Ausführungsform des strahlungsemittierenden Bauelements. Auf dem Träger 1 sind eine erste Kontaktstruktur 4a und eine zweite Kontaktstruktur 4b angeordnet. Die Strahlungsaustrittsfläche 3 des Halbleiterchips 2 ist über die zweite Kontaktschicht 6 elektrisch leitend mit der zweiten Kontaktstruktur 4b verbunden. Der auf der Strahlungsaustrittsfläche 3 angeordnete Teilbereich der zweiten Kontaktschicht 6 ist in Teilbereichen als Kontaktstege 61 ausgeformt sowie zusätzlich als Rahmen, welcher jeweils die äußeren Enden der Kontaktstege 61 miteinander verbindet. Bei dieser Ausführungsform wird der Halbleiterchip 2 homogen mit Spannung versorgt. Der Halbleiterchip 2 ist von der Passivierungsschicht 5 umgeben. Die Passivierungsschicht 5 stellt auch den Sockel für die zweite Kontaktschicht 6 dar welche von der zweiten Kontaktstruktur 4b zur Strahlungsaustrittsfläche 3 geführt wird.

Figur 4 zeigt eine Ausführungsform des strahlungsemittierenden Bauelements in der schematischen Aufsicht. Diese Ausführungsform zeichnet sich dadurch aus, dass sie einen symmetrischen Aufbau bezüglich der gestrichelten Linie aufweist. Die zweite Kontaktschicht 6 ist auch hier wieder auf der Strahlungsaustrittsfläche 3 des Halbleiterchips 2 als Kontaktstege 61 ausgeformt. Der symmetrische Aufbau des Bauelements sorgt für eine besonders homogene Spannungsversorgung des Halbleiterchips 2 was zu einer besonders homogenen Abstrahlungscharakteristik des Halbleiterchips führt.

Neben den in den Figuren 2, 3 und 4 dargestellten Ausführungsform gibt es jeweils auch Ausführungsformen, in denen die Strahlungsaustrittsfläche 3 zumindest in den Bereichen, in denen keine Stege oder Kontaktschichten vorliegen, komplett mit der Passivierungsschicht 5 beschichtet ist. Aus Gründen der Übersicht ist dies nicht in den Figuren dargestellt. Somit ist der Halbleiterchip 2 jeweils gänzlich gegen Umwelteinflüsse geschützt. Es sind auch Ausführungsformen möglich, in denen zusätzlich auch die Kontaktstege 61 mit einer Passivierungsschicht 5 versehen sind, so dass die gesamte Fläche über der Strahlungsaustrittsfläche 3 mit einer Passivierungsschicht 5 versehen ist.

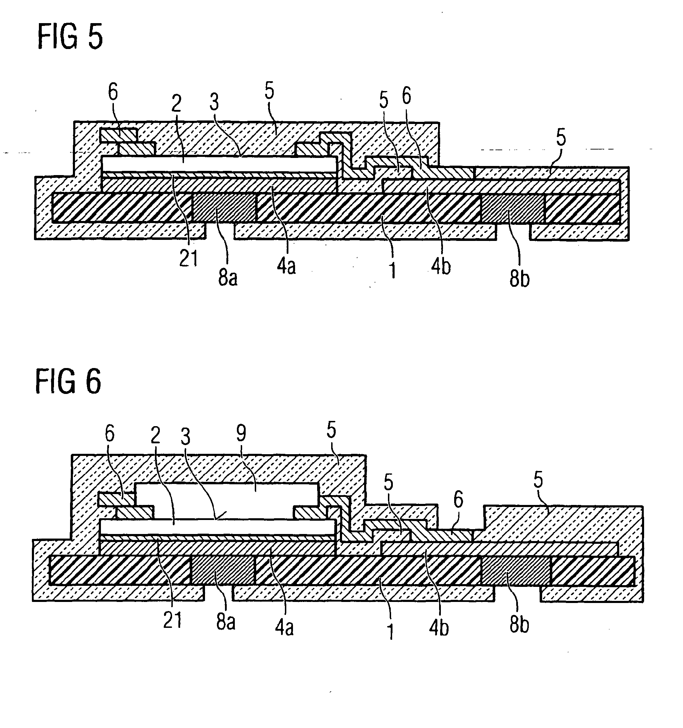

Die Figur 5 zeigt ein Ausführungsbeispiel des strahlungsemittierenden Bauelements in der schematischen Seitenansicht. Hierbei weist der Träger 1 eine erste Durchkontaktierung 8a und eine zweite Durchkontaktierung 8b auf. Durch die Durchkontaktierungen können die erste Kontaktstruktur 4a beziehungsweise die zweite Kontaktstruktur 4b elektrisch leitend von der Unterseite des Bauelements her kontaktiert werden. Die zweite Kontaktschicht 6 ist in dieser Ausführungsform im Bereich, wo sie auf der Strahlungsaustrittsfläche 3 des Halbleiterchips 2 verläuft rahmenförmig ausgeformt. Die Strahlungsaustrittsfläche 3 ist über die zweite Kontaktschicht elektrisch leitend mit der zweiten Kontaktstruktur 4b verbunden. Das gesamte Bauelement ist mit Ausnahme der Kontaktflächen der beiden Durchkontaktierungen 8a und 8b sowie einem Teilbereich der zweiten Kontaktschicht 6 vollständig mit der Passivierungsschicht 5 ummantelt. Somit ist das gesamte Bauelement vor Umwelteinflüssen geschützt.

Das in Figur 5 dargestellte Bauelement ist mittels der ersten und der zweiten Durchkontaktierung 8a, 8b vorzugsweise als oberflächenmontierbares Bauelement ausgebildet.

Die in Figur 6 der schematischen Seitenansicht dargestellte Ausführungsform weist einen vergleichbaren Aufbau auf, wie die Ausführungsform, welche in Figur 5 dargestellt ist. Die in Figur 6 dargestellte Ausführungsform weist zusätzlich ein optisches Element 9 auf. Bei dem optischen Element 9 handelt es sich bei der in Figur 6 dargestellten Ausführungsform um eine Konversionsschicht. Diese Konversionsschicht 9 kann beispielsweise eine konvertierende Substanz umfassen, durch welche die vom Halbleiterchip 2 abgegebene Strahlung oder auch nur Wellenlängenbereiche dieser Strahlung in ihrer Wellenlänge modifiziert wird. Dies kann beispielsweise dadurch erfolgen, dass die vom Halbleiterchip 2 abgegebene Strahlung von dem Konversionsstoff absorbiert wird und von dem Konversionsstoff eine Strahlung emittiert wird, welche eine andere Wellenlänge aufweist, als die Strahlung welche von dem Konversionsstoff absorbiert wurde. Bei dem in Figur 6 dargestellten Ausführungsbeispiel durchläuft die gesamte vom Halbleiterchip 2 abgegebene Strahlung das optische Element 9.

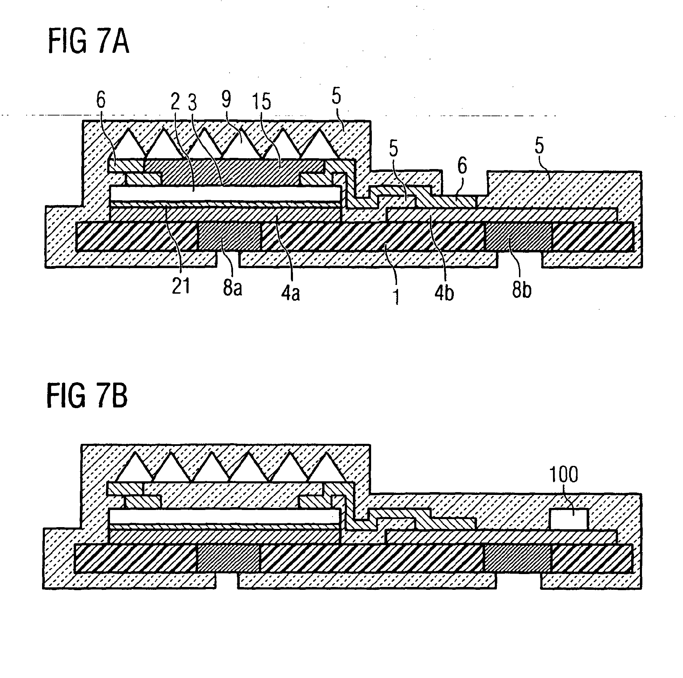

Die in Figur 7a dargestellte Ausführungsform weist einen vergleichbaren Aufbau auf, wie die Ausführungsform welche in Figur 5 dargestellt ist. Die in Figur 7a dargestellte Ausführungsform weist jedoch zusätzlich ein optisches Element 9 auf. Auf der Strahlungsaustrittsfläche 3 befindet sich eine Ausgleichsschicht 15 auf der das optische Element 9 angeordnet ist. Die Ausgleichsschicht 15 kann unter anderem zur Planarisierung der Oberfläche der Strahlungsaustrittsfläche 3 dienen. Die obere Fläche des optischen Elements 9 also die Fläche, welche vom Halbleiterchip 2 abgewandt ist, ist ebenfalls mit einer Passivierungsschicht 5 versehen. Bei dem optischen Element 9 handelt es sich bei diesem Ausführungsbeispiel um Pyramidenfilter. Die Passivierungsschicht 5 kann hierbei in dem Bereich, in dem sie auf den Pyramidenfiltern verläuft, auch eine gleichmäßige Schichtdicke aufweisen. Mit Hilfe dieser Filter kann die vom Halbleiterchip 2 abgegebene Strahlung in ihrer Raumrichtung abgelenkt werden.

Das in Figur 7b dargestellte Ausführungsbeispiel entspricht dem Ausführungsbeispiel wie es in Figur 7a dargestellt ist, enthält jedoch zusätzlich ein passives Bauelement 100. Dieses passive Bauelement 100 ist auf der zweiten Kontaktstruktur angeordnet und ebenfalls gänzlich von der Passivierungsschicht 5 umschlossen. Bei dem passiven Bauelement 100 kann es sich beispielsweise um eine Schutzdiode oder einen Widerstand handeln.

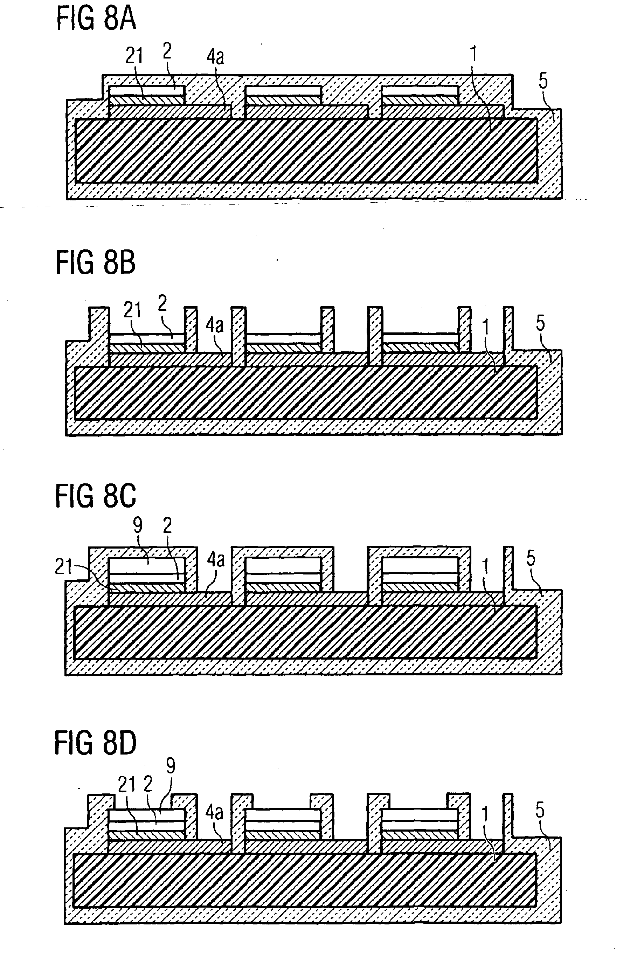

In der Figurenfolge 8a bis 8d sind drei strahlungsemittierende Bauelemente in jeweils verschiedenen Verfahrensstufen dargestellt. In der Figur 8a ist auf dem Träger 1 jeweils eine erste Kontaktstruktur 4a angeordnet und ein Halbleiterchip 2, der sowohl mechanisch wie auch elektrisch leitend über die erste Kontaktschicht 21 mit der ersten Kontaktstruktur 4a verbunden ist. Der gesamte Träger 1 sowie die drei Bauelemente sind jeweils komplett mit der Passivierungsschicht 5 umgeben.

Bei der in Figur 8b dargestellten Verfahrensstufe wurde die Passivierungsschicht 5 über dem Halbleiterchip 2 sowie über der ersten Kontaktstruktur 4a in einem Teilbereich, auf dem keine erste Kontaktschicht 21 angeordnet ist, freigelegt. Das Entfernen der Passivierungsschicht 5 kann beispielsweise mittels RIE-Plasmaätzen ("reactive ion etching") mit einem fluorierten Gas (z.B. NF₃, CHF₃, CF₄ oder SF₆) erfolgen.

Bei der in Figur 8c dargestellten Verfahrensstufe wurde auf dem Halbleiterchip 2 ein optisches Element 9 aufgebracht. Bei dem optischen Element 9 handelt es sich bei diesem Ausführungsbeispiel um eine Konversionsschicht. Das Aufbringen der Konversionsschicht kann hierbei beispielsweise über Plättchen erfolgen, die ein Konvertermaterial umfassen. Die Dicke der Konversionsschicht kann beispielsweise 20 µm betragen. Es kann aber auch eine YAG-Keramik, welche beispielsweise mit Ce dotiert ist verwendet werden. Hier würde die Dicke beispielsweise 100 µm betragen. Nach dem Aufbringen des optischen Elements 9 wurde über das optische Element 9 wieder eine Passivierungsschicht 2 aufgebracht.

Bei der in Figur 8d dargestellten Verfahrensstufe wurde ein Teilbereich der Passivierungsschicht 5 der über dem optischen Element 9 verläuft wieder entfernt. Dieses Entfernen der Passivierungsschicht kann beispielsweise mittels RIE-Plasmaätzen ("reactive ion etching") mit einem fluoriertem Gas erfolgen. Durch das Freilegen des optischen Elements 9 kann die Absorption der emittierten Strahlung verringert werden.

In der Figurenfolge 9a bis 9d ist ein Ausführungsbeispiel des strahlungsemittierenden Bauelements in vier unterschiedlichen Verfahrensstufen jeweils schematisch in der Aufsicht dargestellt.

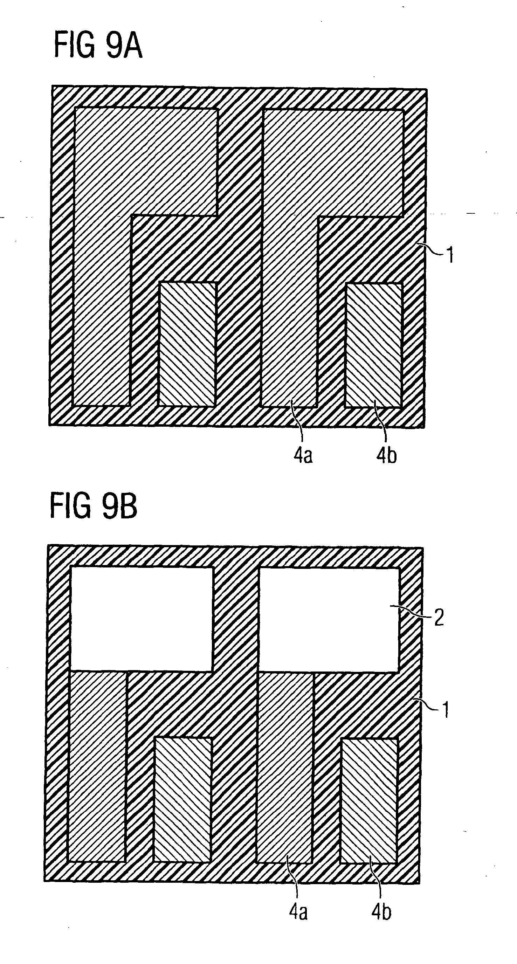

Die Figur 9a zeigt den Träger 1 auf dem jeweils für zwei strahlungsemittierende Bauelemente die erste Kontaktstruktur 4a und die zweite Kontaktstruktur 4b dargestellt sind.

Die Figur 9b zeigt ein Ausführungsbeispiel welches beispielsweise aus den in Figur 9a dargestellten Bauelementen hervorgehen könnte, das auf einem Teilbereich der ersten Kontaktstruktur 4a jeweils ein Halbleiterchip 2 aufgebracht wurde. Das Aufbringen des Halbleiterchips 2 kann beispielsweise durch Bonden, Löten oder Kleben erfolgen. Hierbei kann zwischen dem Halbleiterchip 2 und der ersten Kontaktstruktur 4a eine erste Kontaktschicht 21 angeordnet sein.

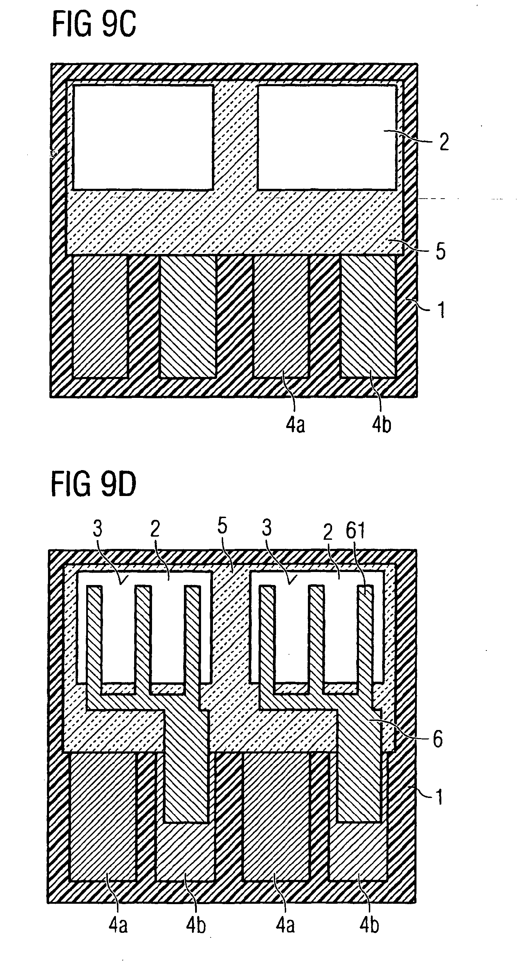

Die in Figur 9c dargestellte Verfahrensstufe kann beispielsweise aus der Verfahrensstufe wie sie in Figur 9b dargestellt ist hervorgehen, dadurch dass eine Passivierungsschicht 5 aufgebracht wurde. Die Passivierungsschicht 5 umschließt hierbei jeweils die Halbleiterchips 2. Die Passivierungsschicht 5 kann beispielsweise mittels chemischer Gasphasenabscheidung (CVD), vorzugsweise mittels plasmaunterstützter Gasphasenabscheidung (PECVD) abgeschieden werden.

Die in Figur 9d dargestellte Verfahrensstufe entspricht dem Ausführungsbeispiel, wie es in Figur 2 dargestellt ist. Dieses könnte beispielsweise aus der Verfahrensstufe wie sie in Figur 9c dargestellt ist hervorgehen, dadurch dass auf jedem Bauelement jeweils die zweite Kontaktschicht 6 aufgebracht wurde. Die zweite Kontaktschicht 6 ist hierbei in den Teilbereichen in denen sie auf dem Halbleiterchip 2 verläuft als Kontaktstege 61 ausgeformt.

In einem weiteren Verfahrensschritt, welcher nicht als Figur dargestellt ist, könnte nun die frei liegende Strahlungsaustrittsfläche 3 sowie auch die Kontaktstege 61 auch mit einer Passivierungsschritt 5 überzogen werden. Somit wäre dann der gesamte Halbleiterchip 2 durch die Passivierungsschicht vor Umwelteinflüssen geschützt.

## Patentansprüche

1. Strahlungsemittierendes Bauelement, umfassend
- einen Träger (1),
- einen Halbleiterchip (2) angeordnet auf dem Träger (1), wobei der Halbleiterchip (2) eine aktive Schicht zur Erzeugung von elektromagnetischer Strahlung und eine Strahlungsaustrittsfläche (3) aufweist,
- eine erste und eine zweite Kontaktstruktur (4a, 4b) zur elektrischen Kontaktierung des Halbleiterchips (2),
- eine erste (21) und eine zweite Kontaktschicht (6), wobei der Halbleiterchip (2) über die erste Kontaktschicht (21) mit der ersten Kontaktstruktur (4a) und über die zweite Kontaktschicht (6) mit der zweiten Kontaktstruktur (4b) elektrisch leitend verbunden ist,
- eine Passivierungsschicht (5) angeordnet auf dem Halbleiterchip (2), wobei die Passivierungsschicht (5) ein organisches Polymer umfasst, mit der allgemeinen Formel (I): 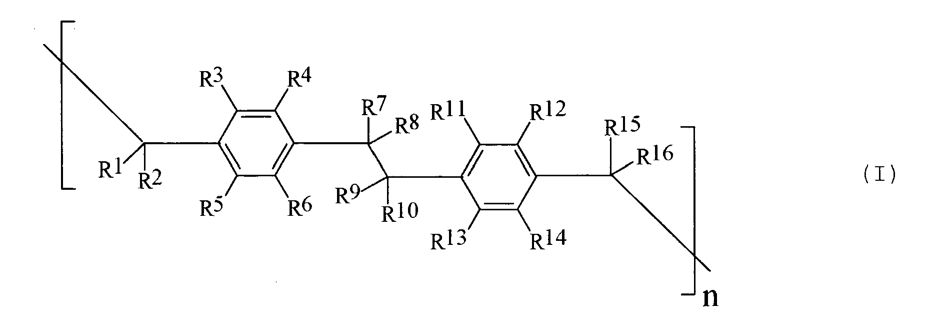 wobei die Reste R¹ bis R¹⁶ jeweils unabhängig voneinander H, CH₃, F, Cl oder Br sein können, und n einen Wert von 10 bis 500.000 hat.

2. Strahlungsemittierendes Bauelement nach Anspruch 1, wobei R¹, R², R⁷, R⁸, R⁹, R¹⁰, R¹⁵ und R¹⁶ jeweils für H steht.

3. Strahlungsemittierendes Bauelement nach einem der vorhergehenden Ansprüche,
wobei zumindest Teilbereiche der Passivierungsschicht (5) die äußerste Schicht des Bauelements darstellen.

4. Strahlungsemittierendes Bauelement nach einem der vorhergehenden Ansprüche,
wobei die Passivierungsschicht (5) auf der Strahlungsaustrittsfläche (3) angeordnet ist.

5. Strahlungsemittierendes Bauelement nach einem der vorhergehenden Ansprüchen,
wobei auf der Strahlungsaustrittsfläche (3) des Halbleiterchips (2) zumindest ein optisches Element (9) angeordnet ist.

6. Strahlungsemittierendes Bauelement nach Anspruch 5,
wobei das optische Element (9) eine Konversionsschicht oder einen Filter umfasst.

7. Strahlungsemittierendes Bauelement nach einem der Ansprüche 5 oder 6,
wobei die Passivierungsschicht (5) zumindest auf Teilbereichen der vom Halbleiterchip (2) abgewandten Oberfläche des optischen Elements (9) angeordnet ist.

8. Strahlungsemittierendes Bauelement, nach einem der vorhergehenden Ansprüche,
wobei die Passivierungsschicht (5) die erste Kontaktstruktur (4a) gegen die zweite Kontaktstruktur (4b) elektrisch isoliert.

9. Strahlungsemittierendes Bauelement nach einem der vorhergehenden Ansprüche,
wobei die Passivierungsschicht (5) die zweite Kontaktschicht (6) gegen die erste Kontaktstruktur (4a) elektrisch isoliert.

10. Strahlungsemittierendes Bauelement nach einem der vorhergehenden Ansprüche,
wobei die zweite Kontaktschicht (6) auf der Strahlungsaustrittsfläche (3) des Halbleiterchips (2) rahmenförmig angeordnet ist.

11. Strahlungsemittierendes Bauelement nach einem der vorhergehenden Ansprüche,
wobei die zweite Kontaktschicht (6) Kontaktstege (61) aufweist, die auf der Strahlungsaustrittsfläche (3) des Halbleiterchips (2) angeordnet sind.

12. Strahlungsemittierendes Bauelement nach einem der vorhergehenden Ansprüche,
wobei durch den Träger (1) eine erste und eine zweite Durchkontaktierung (8a, 8b) vorhanden ist, und die erste Durchkontaktierung (8a) mit der ersten Kontaktstruktur (4a) und die zweite Durchkontaktierung (8b) mit der zweiten Kontaktstruktur (4b) elektrisch leitend verbunden sind.

13. Strahlungsemittierendes Bauelement nach einem der vorhergehenden Ansprüche,
wobei das Bauelement als Dünnfilmchip ausgeformt ist.

14. Verfahren zur Herstellung eines strahlungsemittierenden Bauelements mit den Verfahrensschritten:
A) Bereitstellen eines Trägers (1), der eine erste und eine zweite Kontaktstruktur (4a, 4b) aufweist,
B) mechanisches und elektrisch leitendes Verbinden eines Halbleiterchips (2) mit der ersten Kontaktstruktur (4a) über eine erste Kontaktschicht (21), wobei der Halbleiterchip (2) eine aktive Schicht zur Erzeugung von elektromagnetischer Strahlung und eine Strahlungsaustrittsfläche (3) aufweist,
C) mechanisches und elektrisch leitendes Verbinden des Halbleiterchips (2) mit der zweiten Kontaktstruktur (4b) über eine zweite Kontaktschicht (6),
D) Aufbringen einer Passivierungsschicht (5) auf zumindest Teilbereichen des Halbleiterchips (2),
wobei für die Passivierungsschicht (5) ein Material verwendet wird, welches ein organisches Polymer umfasst, mit der allgemeinen Formel (I): 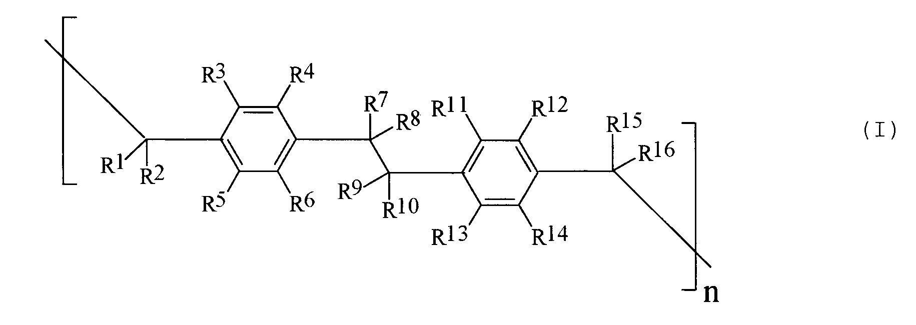 wobei die Reste R¹ bis R¹⁶ jeweils unabhängig voneinander H, CH₃, F, Cl oder Br sein können und n einen Wert von 10 bis 500.000 hat.

15. Verfahren nach Anspruch 14,
wobei die Passivierungsschicht (5) mit einem Plasma-Verfahren aufgebracht wird.

## Claims

1. Radiation-emitting component comprising
- a carrier (1),
- a semiconductor chip (2) arranged on the carrier (1), the semiconductor chip (2) having an active layer for generation of electromagnetic radiation and a radiation exit surface (3),
- a first and a second contact structure (4a, 4b) for electrical contact connection of the semiconductor chip (2),
- a first (21) and a second contact layer (6), the semiconductor chip (2) being connected with electrical conduction to the first contact structure (4a) via the first contact layer (21) and to the second contact structure (4b) via the second contact layer (6),
- a passivation layer (5) arranged on the semiconductor chip (2), wherein the passivation layer (5) comprises an organic polymer having the general formula (I): 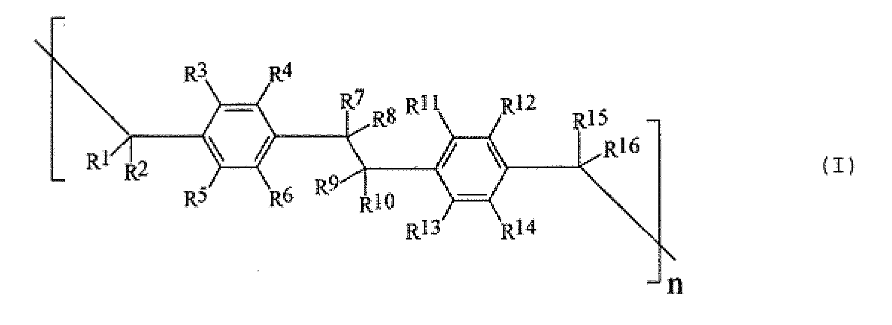 where the R¹ to R¹⁶ radicals may each independently be H, CH₃, F, Cl or Br, and n has a value from 10 to 500 000.

2. Radiation-emitting component according to Claim 1, where R¹ R² R⁷, R⁸ R⁹, R¹⁰, R¹⁵ and R¹⁶ are each H.

3. Radiation-emitting component according to either of the preceding claims,
wherein at least partial regions of the passivation layer (5) constitute the outermost layer of the component.

4. Radiation-emitting component according to any of the preceding claims,
wherein the passivation layer (5) is disposed on the radiation exit surface (3).

5. Radiation-emitting component according to any of the preceding claims,
wherein at least one optical element (9) is disposed on the radiation exit surface (3) of the semiconductor chip (2).

6. Radiation-emitting component according to Claim 5,
wherein the optical element (9) comprises a conversion layer or a filter.

7. Radiation-emitting component according to either of Claims 5 and 6,
wherein the passivation layer (5) is disposed at least on partial regions of the surface of the optical element (9) remote from the semiconductor chip (2).

8. Radiation-emitting component according to any of the preceding claims,
wherein the passivation layer (5) electrically insulates the first contact structure (4a) from the second contact structure (4b).

9. Radiation-emitting component according to any of the preceding claims,
wherein the passivation layer (5) electrically insulates the second contact layer (6) from the first contact structure (4a).

10. Radiation-emitting component according to any of the preceding claims,
wherein the second contact layer (6) is disposed in the form of a frame on the radiation exit surface (3) of the semiconductor chip (2).

11. Radiation-emitting component according to any of the preceding claims,
wherein the second contact layer (6) has contact webs (61) disposed on the radiation exit surface (3) of the semiconductor chip (2).

12. Radiation-emitting component according to any of the preceding claims,
wherein a first and a second through-contact (8a, 8b) are present through the carrier (1), and the first through-contact (8a) is connected with electrical conduction to the first contact structure (4a), and the second through-contact (8b) with electrical conduction to the second contact structure (4b).

13. Radiation-emitting component according to any of the preceding claims,
wherein the component is in the form of a thin-film chip.

14. Process for producing a radiation-emitting component, comprising the process steps of:
A) provision of a carrier (1) having a first and a second contact structure (4a, 4b),
B) mechanical and electrically conductive connection of a semiconductor chip (2) to the first contact structure (4a) via a first contact layer (21), the semiconductor chip (2) having an active layer for generation of electromagnetic radiation and a radiation exit surface (3),
C) mechanical and electrically conductive connection of the semiconductor chip (2) to the second contact structure (4b) via a second contact layer (6),
D) application of a passivation layer (5) to at least partial regions of the semiconductor chip (2),
using, for the passivation layer (5), a material comprising an organic polymer having the general formula (I): 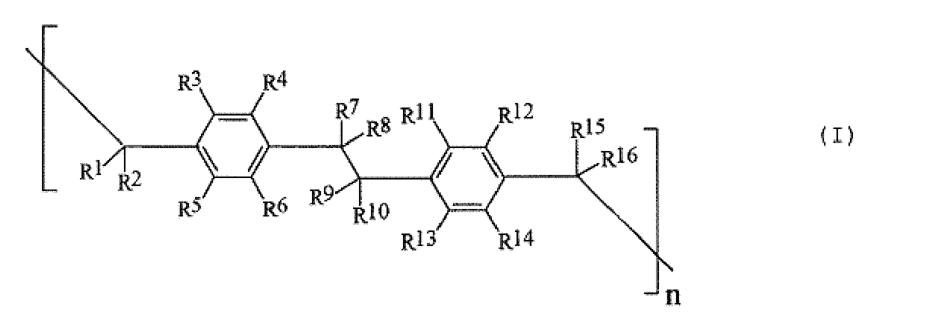 where the R¹ to R¹⁶ radicals may each independently be H, CH₃, F, Cl or Br and n has a value from 10 to 500 000.

15. Process according to Claim 14,
wherein the passivation layer (5) is applied by a plasma process.

## Revendications

1. Composant émettant un rayonnement et comprenant :
un support (1),
une puce semi-conductrice (2) disposée sur le support (1),
la puce semi-conductrice (2) présentant une couche active qui produit un rayonnement électromagnétique et une surface (3) de sortie du rayonnement,
une première et une deuxième structure de contact (4a, 4b) qui assurent le contact électrique de la puce semi-conductrice (2),
une première couche de contact (21) et une deuxième couche de contact (6),
la puce semi-conductrice (2) étant reliée de manière électriquement conductrice à la première structure de contact (4a) par l'intermédiaire de la première couche de contact (21) et à la deuxième structure de contact (4b) par l'intermédiaire de la deuxième couche de contact (6),
une couche de passivation (5) disposée sur la puce semi-conductrice (2),
la couche de passivation (5) comportant un polymère organique de formule générale (I) : 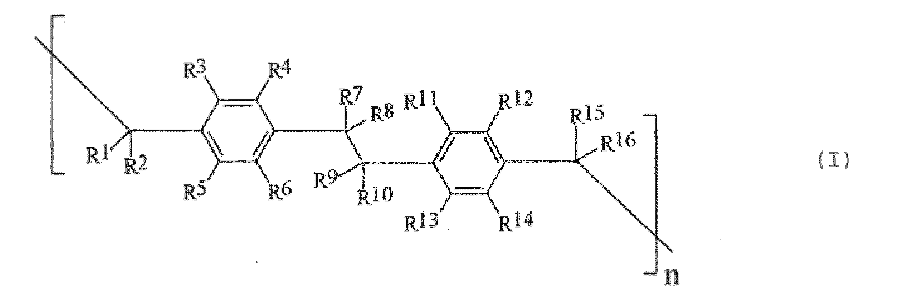 dans laquelle les groupes R¹ à R¹⁶ peuvent représenter indépendamment les uns des autres H, CH₃, F, Cl ou Br, n ayant une valeur comprise entre 10 et 500 000.

2. Composant émettant un rayonnement selon la revendication 1, dans lequel R¹, R², R⁷, R⁸, R⁹, R¹⁰, R¹⁵ et R¹⁶ représentent tous H.

3. Composant émettant un rayonnement selon l'une des revendications précédentes, dans lequel au moins certaines parties de la couche de passivation (5) représentent la couche extérieure du composant.

4. Composant émettant un rayonnement selon l'une des revendications précédentes, dans lequel la couche de passivation (5) est disposée sur la surface (3) de sortie du rayonnement.

5. Composant émettant un rayonnement selon l'une des revendications précédentes, dans lequel au moins un élément optique (9) est disposé sur la surface (3) de sortie du rayonnement de la puce semi-conductrice (2).

6. Composant émettant un rayonnement selon la revendication 5, dans lequel l'élément optique (9) comporte une couche de conversion ou un filtre.

7. Composant émettant un rayonnement selon l'une des revendications 5 ou 6, dans lequel la couche de passivation (5) est disposée au moins sur des parties de la surface de l'élément optique (9) non tournée vers la puce semi-conductrice (2).

8. Composant émettant un rayonnement selon l'une des revendications précédentes, dans lequel la couche de passivation (5) isole électriquement la première structure de contact (4a) vis-à-vis de la deuxième structure de contact (4b).

9. Composant émettant un rayonnement selon l'une des revendications précédentes, dans lequel la couche de passivation (5) isole électriquement la deuxième couche de contact (6) vis-à-vis de la première couche de contact (4a).

10. Composant émettant un rayonnement selon l'une des revendications précédentes, dans lequel la deuxième couche de contact (6) est disposée en forme de cadre sur la surface (3) de sortie de rayonnement de la puce semi-conductrice (2).

11. Composant émettant un rayonnement selon l'une des revendications précédentes, dans lequel la deuxième couche de contact (6) présente des nervures de contact (61) disposées sur la surface (3) de sortie de rayonnement de la puce semi-conductrice (2).

12. Composant émettant un rayonnement selon l'une des revendications précédentes, dans lequel un premier et un deuxième passage de contact (8a, 8b) sont prévus à travers le support (1), le premier passage de contact (8a) étant relié électriquement à la première structure de contact (4a) et le deuxième passage de contact (8b) à la deuxième structure de contact (4b).

13. Composant émettant un rayonnement selon l'une des revendications précédentes, dans lequel le composant est configuré sous la forme d'une puce en film mince.

14. Procédé de fabrication d'un composant émettant du rayonnement, le procédé présentant les étapes suivantes :
A) prévoir un support (1) qui présente une première et une deuxième structure de contact (4a, 4b),
B) relier mécaniquement et électriquement une puce semi-conductrice (2) à la première structure de contact (4a) par l'intermédiaire d'une première couche de contact (21), la puce semi-conductrice (2) présentant une couche active qui produit le rayonnement électromagnétique et une surface (3) de sortie du rayonnement,
C) relier mécaniquement et électriquement la puce semi-conductrice (2) à la deuxième structure de contact (4b) par l'intermédiaire d'une deuxième couche de contact (6),
D) appliquer une couche de passivation (5) sur au moins certaines parties de la puce semi-conductrice (2) en utilisant pour la couche de passivation (5) un matériau qui comporte un polymère organique de formule générale (I) : 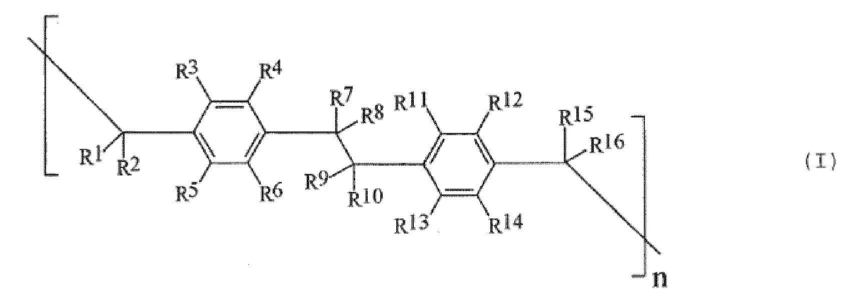 dans laquelle les groupes R¹ à R¹⁶ peuvent représenter indépendamment les uns des autres H, CH₃, F, Cl ou Br, n ayant une valeur comprise entre 10 et 500 000.

15. Procédé selon la revendication 14, dans lequel la couche de passivation (5) est appliquée par un procédé au plasma.
